Europäisches Patentamt

(19) European Patent Office

Office européen des brevets

(11) Publication number : 0 444 756 B1

## (12) EUROPEAN PATENT SPECIFICATION

(45) Date of publication of patent specification :
29.11.95 Bulletin 95/48

(51) Int. Cl.⁶ : H01L 21/02, F26B 5/08

(21) Application number : 91200413.2

(22) Date of filing : 26.02.91

(54) Method of removing in a centrifuge a liquid from a surface of a substrate.

(30) Priority : 01.03.90 NL 9000484

(43) Date of publication of application :
04.09.91 Bulletin 91/36

(45) Publication of the grant of the patent :
29.11.95 Bulletin 95/48

(84) Designated Contracting States :
DE FR GB IT NL

(56) References cited :
EP-A- 0 385 536
US-A- 4 746 397
PATENT ABSTRACTS OF JAPAN vol. 7, no.
292 (E-219)(1437) 27 December 1983, & JP-A-58
168238
PATENT ABSTRACTS OF JAPAN vol. 8, no.
226 (E-272)(1663) 17 October 1984, & JP-A-59
107519

(73) Proprietor : Philips Electronics N.V.
Groenewoudseweg 1
NL-5621 BA Eindhoven (NL)

(72) Inventor : Leenaars, Adriaan Franciscus Maria
c/o INT. OCTROOIBUREAU B.V.,
Prof. Holstlaan 6
NL-5656 AA Eindhoven (NL)
Inventor : Huethorst, Johanna Antoinette
Maria
c/o INT. OCTROOIBUREAU B.V.,
Prof. Holstlaan 6
NL-5656 AA Eindhoven (NL)
Inventor : Marra, Johannes
c/o INT. OCTROOIBUREAU B.V.,
Prof. Holstlaan 6
NL-5656 AA Eindhoven (NL)

(74) Representative : Rensen, Jan Geert et al
INTERNATIONAAL OCTROOIBUREAU B.V.,
Prof. Holstlaan 6
NL-5656 AA Eindhoven (NL)

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a method removing a liquid from a surface of a substrate, in which the substrate is placed in a centrifuge and is then subjected therein to a rotary movement the substrate being rotated at such a speed that the liquid is centrifuged from the surface.

Such a method may be used, for example, in the manufacture of integrated semiconductor circuits (IC's), of display screens comprising liquid crystals (L.C. displays), of electric circuits on boards of synthetic material (circuit boards) and of video and phono records (VLP's and CD's). In all these cases, substrates of semiconductor material, glass or synthetic material are often treated many times in a liquid, for example in galvanic baths for deposition of metals, in etching baths for etching patterns into metal layers or into semiconductor material, in developing baths for developing exposed photolacquer layers and in rinsing baths for cleaning the substrates. Subsequently, the liquid should always be removed from the surface of the substrates.

From the abstract of Japanese Patent Application No. 60-113431 published in "Patent Abstracts of Japan", No. 266 (E 352), Vol. 9, p. 111, 23-10-1985, a method is known of the kind mentioned in the opening paragraph, in which a slice-shaped semiconductor substrate is arranged in a centrifuge on a turntable and is then rotated rapidly about an axis transverse to its surface.

It has been found in practice that with the use of known methods described contaminations dissolved in the solution can remain on the surface of the substrate. These contaminations are often of metallic or organic nature and can be very disturbing during further steps of processing the substrate. Organic contaminations which locally remain on the surface may, for example, strongly delay or even prevent locally an etching treatment.

The invention has for its object to provide a method in which the said disadvantages are obviated.

For this purpose, according to the invention, the method mentioned in the opening paragraph is characterized in that the substrate is brought in the centrifuge into contact with a vapour of a material which is miscible with the liquid and which, when mixed with this liquid, yields a mixture having a surface tension which is lower than that of the liquid.

As compared with the known method, the method according to the invention yields a considerably cleaner result. Comparison tests have shown that, when mixed vapour is introduced into the centrifuge, the quantity of material remaining on the substrate can be reduced by at least a factor 10.

Experiments in which a flow of gas containing the aforementioned vapour is passed over a surface of a substrate on which a liquid film is disposed have shown that the liquid film is split up into parts and that these parts are further contracted to liquid drops. When the flow of gas is interrupted, again a liquid film is formed. It is presumed that the Marangoni effect then plays a part and that the drop formation is due to local differences in surface tension in the liquid caused by supply of the vapour. Since, when the vapour is supplied, the liquid is contracted to smaller and hence thicker liquid parts, during treatment in the centrifuge the liquid will not only be held less strongly by the surface, but will also evaporate more slowly. During the treatment, due to the step according to the invention, a larger quantity of liquid will therefore be removed from the surface by centrifuging and a smaller quantity thereof will be removed by evaporation. Since a smaller quantity of liquid disappears from the surface by evaporation, also a smaller quantity of contaminations dissolved in the liquid will therefore remain on the surface.

According to the invention, the vapour is preferably brought into contact with the substrate in the unsaturated state. Thus, it is prevented that during treatment in the centrifuge vapour is condensed on the surface of the substrate. This condensed vapour will have to be removed by means of an additional drying treatment. Since vapour is extremely clean, the surface will then not be additionally contaminated, however. The use of unsaturated vapour therefor does not yield a cleaner surface, but renders the said additional drying treatment superfluous.

The vapour can be brought in a simple manner into contact with the substrate in the unsaturated state in that this vapour is cooled to a temperature which is lower than that of the substrate.

Preferably, according to the invention, the substrate is already brought into contact with the vapour of the material miscible with the liquid before it is subjected to the rotary movement in the centrifuge. Drops are then formed on the surface of the substrate already before the rotary movement begins. The contraction of liquid to drops takes place much easier when the substrate is stationary than when the substrate rotates. In this manner, the surface becomes cleaner than when the supply of vapour is started only during the rotary movement.

As has already been stated before, substrates can be treated in different liquid baths. In practice, these baths mostly contain water, however. In these cases, preferably a vapour of an organic solvent is passed into the centrifuge. It has been found that the supply of vapour of many alcohols, glycols, aldehydes, esters and ketones can lead to a clean surface.

Preferably, the substrate is brought into contact with the vapour in that this vapour is mixed with a carrier gas and in that this mixture is then passed into the centrifuge. Thus, in a simple manner, unsaturated vapour can be passed into the centrifuge.

The invention will now be described more fully, by way of example, with reference to a drawing and a few embodiments. In the drawing:

Fig. 1 shows a diagrammatic cross-section of a centrifuge for carrying out the method according to the invention,

Figures 2 and 3 show diagrammatically the substrate surface with liquid before and after supply of vapour to the centrifuge shown in Fig: 1,

Fig. 4 shows a diagrammatic cross-section of a centrifuge with a supply of vapour deviating from that in the centrifuge shown in Fig. 1, and

Fig. 5 shows diagrammatically the substrate surface with liquid after supply of the vapour to the centrifuge shown in Fig. 4.

A substrate 1, in this case a slice of silicon having a cross-section of 15 cm, which has a surface 2 on which a liquid 3 is disposed, is placed in a centrifuge 4 on a turntable 5. The turntable 5 is provided with a chamber 6, which communicates through ducts 7 with the surface 2. The turntable 5 is rotatably arranged in the centrifuge 4 on a rotary shaft 8 rotatable in a bearing 9. The rotary shaft 8 is provided with a duct 10, which communicates with the chamber 6. Via the duct 10, the chamber 6 can be brought to a subatmospheric pressure so that the substrate 1 is sucked via the ducts 7 onto the substrate holder 5. The centrifuge is closed by a cover 19 engaging a rubber ring 20. The cover 19 is located at a distance of a few millimetres from the slice of silicon 1 and has a vapour outlet opening 21.

After the substrate 1 has been sucked onto the turntable 5, the latter is set into motion, the substrate 1 being rotated so rapidly that the liquid 3 is centrifuged from the surface 2. The liquid is further removed via a drain 11.

In this example, the substrate 1 is placed at the centre of the turntable, but the liquid 3 is also centrifuged from the surface 2 of the substrate when several substrates are arranged on the (then larger) turntable, or when a number of substrates are placed on a number of turntables at a certain distance one above the other. The centrifuge 4 may of course also be used to dry substrates other than silicon slices, such as glass plates and plates of synthetic material, on which, for example, electric circuits are provided.

According to the invention, the substrate 1 is brought into contact in the centrifuge 4 with a vapour of a material which is miscible with the liquid and, when mixed with the liquid, yields a mixture having a surface tension which is lower than that of the liquid. Thus, as will appear, a more satisfactory and more rapid drying of the substrate 1 is obtained.

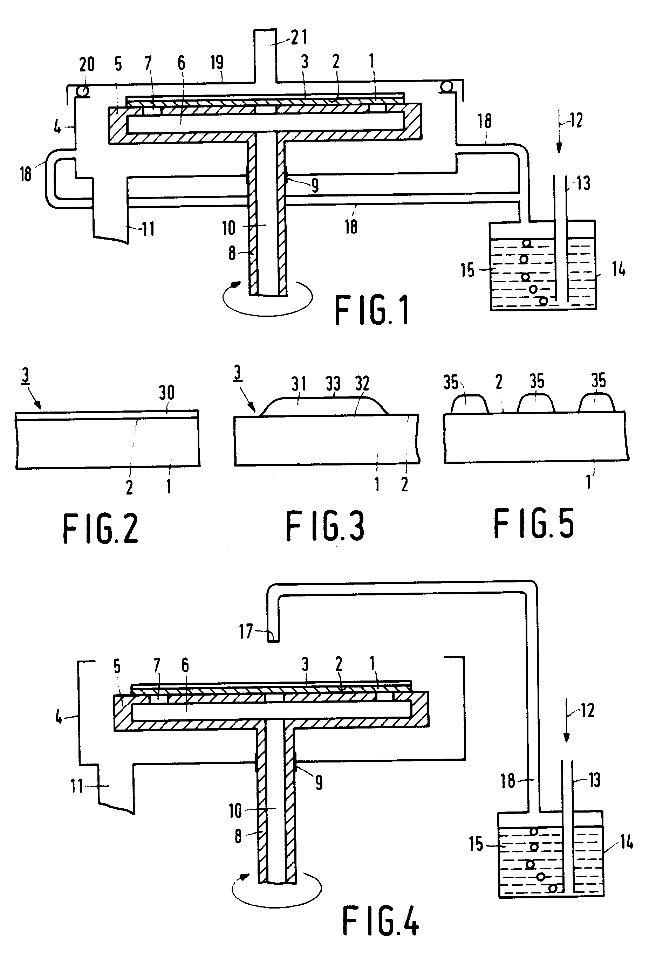

It appears that the liquid 3, which, as is shown diagrammatically in Fig. 2, initially was present as a liquid film 30 on the surface 2 of the substrate 1, is split up, as is shown diagrammatically in Fig. 3, into a smaller, but thicker liquid part 31. Such a liquid part 31 has a comparatively small contact surface 32 with the surface 2 and a comparatively small free surface 33. As a result, during its treatment in the centrifuge 4, the liquid 3 will not only be held less strongly by the surface 2, but will also evaporate more slowly. During the treatment, due to the supply of the vapour, a larger quantity of liquid will therefore be removed from the surface by centrifuging and a smaller quantity thereof will be removed by evaporation. Since a smaller quantity of liquid disappears from the surface by evaporation, also a smaller quantity of contaminations dissolved in the liquid will remain on the surface.

Preferably, according to the invention, the substrate 1 is already brought into contact with the vapour before it is subjected to the rotary movement in the centrifuge 4. The contraction of the liquid 3 to a liquid part 31 takes place much easier when the substrate 1 is stationary than when the substrate rotates. Thus, a more satisfactory and more rapid drying of the substrate can be attained.

In practice, the liquid often is water. A satisfactory and rapid drying is then obtained if an organic solvent is used as material miscible with the liquid. Preferably, a carrier gas indicated diagrammatically by an arrow 12 is passed via a pipe 13 through a container 14 with this solvent 15. As a result, the carrier gas 12 is mixed with vapour of the solvent 15. The carrier gas 12 mixed with vapour of the solvent 15 is passed through pipes 18 into the lower part of the centrifuge. This takes place in such a manner that the flow of gas of the mixture is small near the surface 2 of the substrate 1. The gas mixture is discharged through the opening 21. Thus, in a simple manner, unsaturated vapour is passed over the substrate.

According to the invention, the vapour is brought into contact with the substrate 1 preferably in the unsaturated state. As a result, vapour is prevented from being condensed on the substrate during the treatment in a centrifuge. This condensed vapour would then have to be removed by means of an additional drying treatment.

In a simple manner, the vapour can be brought into contact with the substrate 1 in the unsaturated state in that this vapour is cooled to a temperature which is lower than that of the substrate 1. This may be obtained, for example, in that the solvent 15 in the container 14 is cooled in a usual manner to this lower temperature. Otherwise it has been found that, when the carrier gas 12 is passed through the solvent 15, this gives rise to the forced evaporation of the solvent 15 and hence to a decrease in temperature which in practice is sufficient to prevent the vapour from being condensed on the substrate.

Figure 4 shows a diagrammatic cross-section of a centrifuge with a vapour supply and discharge deviating from that described above. The carrier gas 12 mixed with vapour of the solvent 15 is passed via a pipe 18 with moulded opening 17 into the upper part of the centrifuge 4. The gas mixture is passed into the centrifuge in such a manner that gas flows from the centre along the surface 2 of the substrate 1. It has been found that the liquid, which was initially present as a liquid film 30 on the surface 2 of the substrate 1, (see Figure 2) is split up, as shown diagrammatically in Figure 5, into a number of smaller, but thicker liquid parts 35. Also these parts can be centrifuged more readily from the surface than the film 30 so that also in this case it is achieved that evaporation of the liquid 3 during the treatment is limited.

A number of silicon slices having a cross-section of about 10 cm are successively cleaned in usual solutions of HF, $NH_4OH$-$H_2O_2$ and $HCl$-$H_2O_2$ and are cleaned again additionally in an UV ozone cabinet. A silicon slice is secured on the turntable 5 of the centrifuge 4 is then wetted with 2 mls of a salt solution (in water) diluted to 0.1 M $MgCl_2$. The slice is then fully coated with an about 113 $\mu$m thick liquid film. About 1 second before the latter is rotated a vapour is passed into the centrifuge shown in Figure 1. The vapour is obtained in that a carrier gas, in this example nitrogen gas, is passed through the container 14 filled with an organic solvent at about rotation, the vapour being also passed over the surface 2 during the rotation. The following table indicates a number of results.

| Exp. nr. | Carrier gas | Solvent | Vapour pressure solvent | Residual material $\mu$g/slice | | | |
|---|---|---|---|---|---|---|---|
| | | | | 17r/s | 50r/s | 8r/s | 5r/s |
| 1 | – | – | | 78 | 51 | | |
| 2 | $N_2$ | – | | 80 | 52 | | |
| 3 | $N_2$ | hexanol | 100 | 60 | 53 | | |
| 4 | $N_2$ | isopropanol | 4400 | 21 | 27 | | |
| 5 | $N_2$ | diacetone alcohol | 150 | 7 | 10 | 5 | 5 |
| 6 | $N_2$ | 1-methoxy-2-propanol | 1100 | 4 | 9 | 4 | 3 |
| 7 | $N_2$ | ethylglycol | 500 | 5 | 10 | | |
| 8 | $N_2$ | methyl-pyrrolidon | 30 | 26 | 34 | | |

The residual material is the quantity of material, mainly $MgCl_2$, which remains on the silicon slice after drying in the centrifuge. During the experiments, the temperature of the substrates was about 22°C and that of the vapour about 20°C. In experiment No. 1, the liquid is removed from the substrate without a carrier gas mixed with a vapour being brought into contact with the substrate. The whole quantity of liquid then has been removed after about 1 minute. In experiment No. 2, only carrier gas (nitrogen) is brought into contact with the substrate. The quantity of residual material found is not changed thereby. However, the time required for removing the whole quantity of liquid becomes shorter. In the following experiments, each time a vapour of an organic solvent is mixed with the carrier gas and is brought into contact with the substrate. This is effected at four different speeds of rotation of the turntable, i.e. at 5, 8, 17 and 50 rev/sec. It appears from the table that the best results are obtained at the lowest speed of rotation (5 rev/sec). Presumably, this is due to the fact that at this low speed the contraction in parts of the liquid film described above is practically not disturbed by the rotary movement. At a higher speed of rotation, this is effected indeed by the higher centrifugal forces, as a result of which the parts are smeared out again to a liquid film, which can be removed less readily. The best results are obtained with the vapour of diacetone alcohol and 1-methoxy-2-propanol at 5 rev/sec. The quantity of residual material is then at least a factor 20 smaller as compared with the case in which the liquid is removed at 17 rev/sec without the substrate being brought into contact with the vapour. In all the experiments mentioned above, the substrate is brought into contact with the vapour about 1 sec. before it is rotated. This time may be chosen to be longer. However, if this time becomes longer than about 15 sec. a substantial part of the water film may already have been removed by evaporation, as a result of which a larger quantity of contaminations remains on the surface. This leads to a less clean result.

## Claims

1. A method of removing a liquid from a surface of a substrate, in which the substrate is placed in a centrifuge and is then subjected therein to a rotary movement, the substrate being rotated at such a speed that the liquid is centrifuged from the surface, characterized in that the substrate is brought into contact in the centrifuge with a vapour of a material which is miscible with the liquid and, when mixed with this liquid, yields a mixture having a surface tension which is lower than that of the liquid.

2. A method as claimed in Claim 1, characterized in that the vapour is brought into contact with the substrate in the unsaturated state.

3. A method as claimed in Claim 2, characterized in that the vapour is brought into contact with the substrate in the unsaturated state in that this vapour is cooled to a temperature which is lower than that of the substrate.

4. A method as claimed in Claim 1, 2 or 3, characterized in that the substrate is already brought into contact with the vapour of the material miscible with the liquid before it is subjected to the rotary movement in the centrifuge.

5. A method as claimed in Claim 4, characterized in that the substrate is brought into contact with the vapour 1 to 15 seconds before it is subjected to the rotary movement.

6. A method as claimed in any one of the preceding Claims, characterized in that an organic solvent is used as material miscible with the liquid.

7. A method as claimed in Claim 6, characterized in that an organic solvent is used from the group comprising isopropanol, 1-methoxy-2-propanol, ethylglycol and diacetone alcohol.

8. A method as claimed in any one of the preceding Claims, characterized in that the substrate is brought into contact with the vapour in that the latter is mixed with a carrier gas and in that this mixture is passed into the centrifuge.

9. A method as claimed in Claim 8, characterized in that the mixture of vapour and carrier gas is passed into the centrifuge in such a manner that, near the surface of the substrate the flow of gas is small.

## Patentansprüche

1. Verfahren zum Entfernen einer Flüssigkeit von einer Oberfläche eines Substrats, wobei das Substrat in einer Zentrifuge plaziert wird und darin dann einer Drehbewegung ausgesetzt wird, wobei das Substrat bei einer solchen Geschwindigkeit gedreht wird, daß die Flüssigkeit von der Oberfläche geschleudert wird, dadurch gekennzeichnet, daß das Substrat in der Zentrifuge mit einem Dampf aus einem mit der Flüssigkeit mischbaren Stoff in Kontakt gebracht wird, der nach dem Mischen mit dieser Flüssigkeit eine Mischung ergibt, die eine Oberflächenspannung hat, die kleiner ist als die der Flüssigkeit.

2. Verfahren nach Anspruch 1, dadurch gekennzeichnet, daß der Dampf in ungesättigtem Zustand mit dem Substrat in Kontakt gebracht wird.

3. Verfahren nach Anspruch 2, dadurch gekennzeichnet, daß der Dampf in ungesättigtem Zustand mit dem Substrat in Kontakt gebracht wird, indem dieser Dampf auf eine Temperatur abgekühlt wird, die niedriger ist als die des Substrats.

4. Verfahren nach Anspruch 1, 2 oder 3, dadurch gekennzeichnet, daß das Substrat bereits mit dem Dampf des mit der Flüssigkeit mischbaren Stoffes in Kontakt gebracht wird, bevor es der Drehbewegung in der Zentrifuge ausgesetzt wird.

5. Verfahren nach Anspruch 4, dadurch gekennzeichnet, daß das Substrat 1 bis 15 Sekunden, bevor es der Drehbewegung ausgesetzt wird, mit dem Dampf in Kontakt gebracht wird.

6. Verfahren nach einem der vorhergehenden Ansprüche, dadurch gekennzeichnet, daß ein organisches Lösungsmittel als der mit der Flüssigkeit mischbare Stoff verwendet wird.

7. Verfahren nach Anspruch 6, dadurch gekennzeichnet, daß ein organisches Lösungsmittel aus der Gruppe mit Isopropanol, 1-Methoxy-2-Propanol, Ethylglycol und Diacetonalkohol verwendet wird.

8. Verfahren nach einem der vorhergehenden Ansprüche, dadurch gekennzeichnet, daß das Substrat mit dem Dampf in Kontakt gebracht wird, indem letzterer mit einem Trägergas gemischt wird und diese Mischung in die Zentrifuge geleitet wird.

9. Verfahren nach Anspruch 8, dadurch gekennzeichnet, daß die Mischung aus Dampf und Trägergas so in die Zentrifuge geleitet wird, daß nahe der Oberfläche des Substrats die Gasströmung klein ist.


**Revendications**

1. Procédé pour enlever un liquide d'une surface d'un substrat, selon lequel le substrat est placé dans une centrifugeuse et est ensuite soumis à un mouvement de rotation, le substrat étant porté à rotation à une vitesse telle que le liquide est centrifugé de la surface, caractérisé en ce que le substrat est porté en contact dans la centrifugeuse avec une vapeur d'un matériau miscible au liquide et, mélangée avec ce liquide, fournit un mélange présentant une tensio-activité inférieure à celle du liquide.

2. Procédé selon la revendication 1, caractérisé en ce que la vapeur est portée en contact avec le substrat à l'état non saturé.

3. Procédé selon la revendication 2, caractérisé en ce que la vapeur est portée en contact avec le substrat à l'état non saturé du fait que cette vapeur est refroidie à une température inférieure à celle du substrat.

4. Procédé selon la revendication 1, 2 ou 3, caractérisé en ce que le substrat est déjà porté en contact avec la vapeur du matériau miscible au liquide avant d'être soumis au mouvement de rotation dans la centrifugeuse.

5. Procédé selon la revendication 4, caractérisé en ce que le substrat est porté en contact avec la vapeur 1 à 15 secondes avant d'être soumis au mouvement de rotation.

6. Procédé selon l'une des revendications précédentes, caractérisé en ce qu'un solvant organique est utilisé comme matériau miscible au liquide.

7. Procédé selon la revendication 6, caractérisé en ce qu'un solvant organique est utilisé du groupe comprenant l'isopropanol, le 1-méthoxy-2-propanol, l'éthylglycol et le diacétone alcool.

8. Procédé selon l'une des revendications précédentes, caractérisé en ce que le substrat est porté en contact avec la vapeur du fait que cette dernière est mélangée avec un gaz porteur et en ce que ce mélange est introduit dans la centrifugeuse.

9. Procédé selon la revendication 8, caractérisé en ce que le mélange de vapeur et de gaz porteur est introduit dans la centrifugeuse de façon que près de la surface du substrat, le flux de gaz soit faible.

FIG.1

FIG.2

FIG.3

FIG.5

FIG.4